# FASCICULE DE BREVET EUROPEEN

(11) **EP 2 333 820 B1**
(45) Date de publication et mention de la délivrance du brevet: **08.01.2014**
(21) Numéro de dépôt: 10354085.2
(22) Date de dépôt: 03.12.2010
(51) Int. Cl.: H01L 21/285, H01L 21/8238

(54) **Procédé de formation de matériaux métalliques comportant des semi-conducteurs**
Verfahren zur Herstellung von Metallmaterialien, die Halbleiter enthalten
Method for forming metal materials comprising semi-conductors

(30) Priorité: 10.12.2009 FR 0905976
(43) Date de publication de la demande: 15.06.2011
(73) Titulaire: Commissariat à l'Énergie Atomique et aux Énergies Alternatives, 75015 Paris (FR)
(72) Inventeur: Carron, Véronique, 38640 Claix (FR); Nemouchi, Fabrice, 38430 Moirans (FR)
(74) Mandataire: de Jong, Jean Jacques

(56) Documents cités:
- US-A- 5 288 666
- US-A- 6 150 248
- US-A1- 2003 162 349
- US-A1- 2005 136 584
- US-A1- 2009 004 850

## Description

### Domaine technique de l'invention

L'invention est relative à un procédé de formation de premier et second matériaux à base de métal dans un dispositif semi-conducteur.

### État de la technique

L'augmentation continue des performances des circuits intégrés, par exemple en termes de consommation et/ou de fréquence de fonctionnement, se traduit inéluctablement par une diminution constante de la taille de ses composants. Afin de réaliser des dispositifs toujours plus performants, de nouvelles architectures et de nouveaux matériaux ont été intégrés dans les transistors.

Cependant, la diminution des dimensions du transistor se traduit par une augmentation de ses résistances d'accès, qui a pour effet de réduire la quantité de courant utilisable et donc de dégrader ses performances. Afin de réduire au maximum les résistances d'accès du transistor, les zones de contact en matériau semi-conducteur sont transformées en un composé intermétallique ayant un comportement métallique. Ce composé intermétallique, appelé par la suite matériau métallique, doit être de moins en moins résistif. De manière conventionnelle, ce matériau métallique, généralement un siliciure, est obtenu en faisant réagir un métal avec le matériau semi-conducteur, en l'occurrence le silicium des zones de contact. Les siliciures de titane (TiSi₂) ou les siliciures de cobalt (CoSi₂), classiquement utilisés, sont remplacés par des siliciures qui présentent de meilleures caractéristiques techniques, par exemple les siliciures de Nickel (NiSi). En effet, les siliciures de nickel présentent une résistivité plus faible, une consommation réduite du silicium et une plus faible température de formation.

En parallèle, dans les transistors, le germanium remplace le silicium ou lui est associé pour améliorer les performances électriques de ce dernier. En effet, la mobilité des porteurs de charge, plus particulièrement des trous, étant plus élevée dans le germanium que dans le silicium, le germanium est particulièrement intéressant pour les applications dites « haute fréquence » qui requièrent un courant d'alimentation élevé. De ce fait, il est important de maîtriser la formation d'un matériau métallique à partir d'un matériau semi-conducteur contenant du germanium.

En présence de germanium, le nickel est le métal le plus fréquemment utilisé en raison des faibles températures requises pour former les composés intermétalliques NiSi₁₋ₓGeₓ et NiGe. Cependant, alors que le nickel est l'espèce diffusante principale pendant la croissance de siliciures et germaniures de nickel, il existe également une diffusion importante du germanium lors de la croissance du germaniure, notamment le long des zones d'isolation du transistor formées de matériau diélectrique.

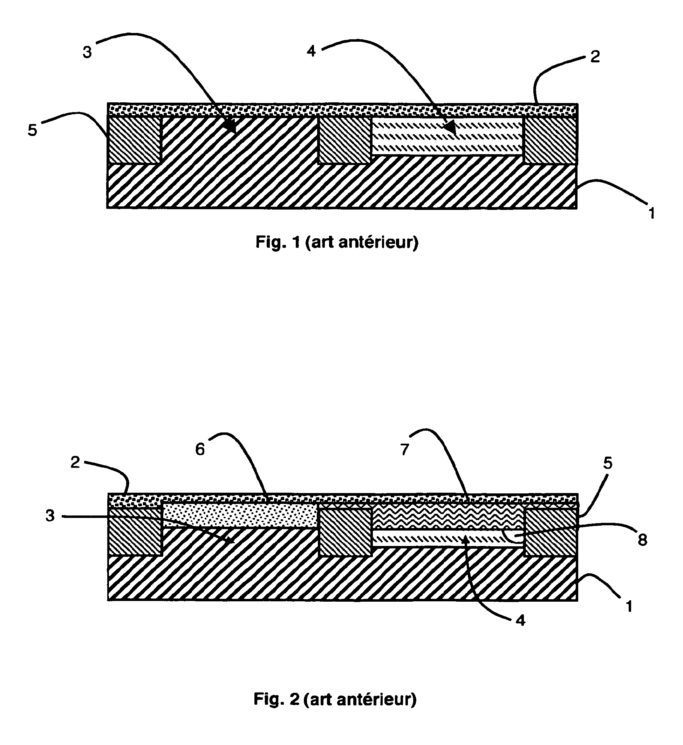

Les figures 1 et 2 représentent la croissance de germaniure et de siliciure de nickel sur un substrat 1 de manière classique.

Comme illustré à la figure 1, une couche de nickel 2 est déposée simultanément sur une zone 3 en silicium, une zone 4 en germanium et des motifs d'isolation 5 en matériau diélectrique, qui encadrent et séparent électriquement les zones adjacentes 3 et 4 en matériaux semi-conducteurs (Si et/ou Ge).

La figure 2 représente l'ensemble, après avoir subi un traitement thermique qui fait réagir la couche de nickel 2 avec le silicium de la zone 3 et le germanium de la zone 4 pour former respectivement un siliciure de nickel 6 et un germaniure de nickel 7.

A cause de la diffusion importante du germanium dans la couche de nickel, ce procédé de réalisation a pour conséquences :
- la formation de germaniure de nickel 7 sur les motifs diélectriques 5, ce qui engendre des courts-circuits,
- la formation de cavités 8 dans la couche de germanium disposée immédiatement sous le germaniure de nickel 7, qui proviennent d'un transport du germanium vers le germaniure de nickel 7.

La formation d'un germaniure de nickel sur les motifs diélectriques 5 traduit une croissance latérale du germaniure de nickel 7. Cette croissance est indifféremment observée pour des couches en germanium qui se trouvent à un niveau supérieur et à un niveau inférieur à celui des motifs 5.

Afin de réduire les problèmes engendrés par la diffusion du germanium, un procédé de formation d'un germaniure de nickel auto-aligné a été proposé dans le document US20070032025. Ce document décrit la formation d'une couche de nickel sur des zones en germanium et la réalisation d'un premier traitement thermique en atmosphère inerte à une température comprise entre 150 °C et 325 °C. Au cours de ce premier traitement thermique, la couche en nickel réagit avec la couche en germanium pour former le germaniure de nickel. Le budget thermique de cette opération est choisi de manière à permettre la réaction entre le nickel et le germanium tout en limitant la diffusion des atomes de germanium. Ainsi, la formation d'un germaniure de nickel au-dessus des zones en matériau diélectrique est très limitée. Le nickel n'ayant pas réagi avec le germanium est ensuite éliminé et un second traitement thermique est réalisé. La température de ce second traitement thermique est plus élevée, entre 325 °C et 400 °C, de manière à convertir le germaniure de nickel précédemment formé et riche en nickel en un monogermaniure de nickel (NiGe) moins résistif que les autres formes de germaniure de nickel.

Ainsi, au moyen de deux traitements thermiques consécutifs, dans des gammes de température très strictes, il est possible de former un monogermaniure de nickel NiGe auto-aligné. Cependant, cette approche est très difficile à maîtriser pour une co-intégration de siliciure de nickel et de germaniure de nickel. En effet, le budget thermique nécessaire à la formation d'un siliciure de nickel est supérieur à celui nécessaire à la formation d'un germaniure de nickel. Ainsi, le premier budget thermique requis pour la formation du germaniure de nickel engendre la formation d'un siliciure de nickel qui est très riche en nickel. Ce siliciure de nickel est trop riche en nickel et le nickel n'ayant pas réagi ne peut être éliminé sélectivement vis-à-vis du siliciure formé. Il en résulte alors une couche de siliciure de nickel qui est discontinue.

Ce procédé n'est donc pas utilisable pour la réalisation d'une co-intégration de siliciure de nickel et de germaniure de nickel à partir d'un substrat comportant des zones en semi-conducteur comportant du silicium et des zones en semi-conducteur comportant du germanium.

Le document US 6150248 décrit un procédé d'une co-intégration de siliciure de cobalt et de germaniure de cobalt à partir d'un substrat comportant des zones en silicium et des zones en germanium.

### Objet de l'invention

L'invention vise un procédé de formation de matériaux à base de métal simple et facile à mettre en oeuvre, sans risque de courts-circuits entre ces matériaux.

Plus particulièrement, l'invention vise un procédé dont le budget thermique est compatible avec la co-intégration d'un matériau métallique comprenant du silicium et d'un matériau métallique comprenant du germanium.

Selon l'invention, on tend vers ces objectifs en prévoyant un substrat comportant une zone en premier matériau semi-conducteur et une zone en second matériau semi-conducteur comprenant du germanium séparées par un motif en matériau diélectrique, en déposant une couche de métal et en réalisant un premier traitement thermique. La couche de métal réagit au moins partiellement avec le premier matériau semi-conducteur et le second matériau semi-conducteur comprenant du germanium pour former respectivement le premier matériau à base de métal et le second matériau à base de métal et contenant du germanium. Le premier traitement thermique est réalisé sous une atmosphère comprenant une quantité d'oxygène comprise entre 0,01 % et 5 %.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 et 2 représentent, de manière schématique et en coupe, des étapes d'un procédé de formation de matériaux à base de métal selon l'art antérieur,
- la figure 3 représente, sous forme d'organigramme, des étapes d'un procédé de formation de matériaux à base de métal selon l'invention,
- les figures 4 et 5 représentent, de manière schématique et en coupe, des étapes du procédé de la figure 3.

### Description de modes particuliers de réalisation

La figure 1 constitue un point de départ du procédé selon l'invention. Un substrat 1 comporte, sur une surface, une zone 3 en premier matériau semi-conducteur et une zone 4 en second matériau semi-conducteur. De manière classique, le substrat 1 comporte une pluralité de zones en matériaux semi-conducteurs. Dans le cas d'une co-intégration, le substrat comprend une zone 3 en matériau semi-conducteur contenant du silicium et une zone 4 en matériau semi-conducteur contenant du germanium. Selon une variante, l'ensemble des zones peut être uniquement en matériau semi-conducteur contenant du germanium.

Dans le cas d'une co-intégration, le premier matériau semi-conducteur comprend, de préférence, du germanium. Le premier matériau semi-conducteur est, par exemple, un alliage de silicium-germanium Si₁₋ₓGeₓ avec un pourcentage atomique (x) de germanium, appelé également taux de germanium, supérieur ou égal à 30 % (x≥0,3), ou du germanium Ge pur. Le second matériau semi-conducteur comprend, de préférence, du silicium. Le second matériau semi-conducteur est, par exemple, un alliage de silicium-germanium Si₁₋ₓGeₓ, avec une concentration maximale de germanium de 30 % (x≤0,3), ou du silicium Si pur. Les premier et second matériaux semi-conducteurs peuvent être dopés ou intrinsèques.

De manière classique, les zones 3 et 4 sont séparées par un motif 5 en matériau diélectrique isolant. De cette manière, le motif empêche toute diffusion de matière entre ces deux zones. Les zones 3 et 4 constituent, par exemple, une électrode de grille en SiGe et des électrodes de source et de drain en Si ou inversement. Dans ce cas, le motif 5 en matériau diélectrique est constitué par le diélectrique de grille et les espaceurs qui délimitent l'électrode de grille. Comme illustré à la figure 1, les zones 3 et 4 sont, par exemple, des zones actives en silicium et en germanium. Le motif 5 est alors un motif d'isolation électrique latérale qui sépare les zones actives.

Le substrat 1 comporte généralement une pluralité de motifs 5 en matériau diélectrique entre les zones actives. Ces motifs 5 sont réalisés dans des matériaux classiques de l'industrie microélectronique, par exemple, en oxyde de silicium SiO₂, en nitrure de silicium Si₃N₄ ou en matériau diélectrique à forte constante diélectrique, HfO₂ Al₂O₃...

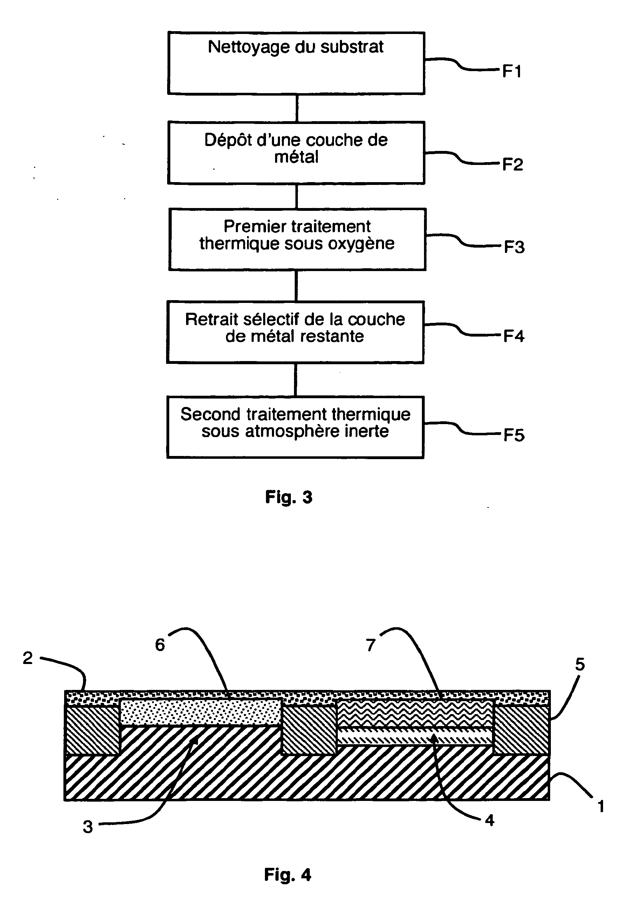

Les figures 3 à 5 illustrent des étapes d'un procédé de formation de matériaux à base de métal à partir de semi-conducteurs.

A la figure 3, une étape de nettoyage F1 est tout d'abord réalisée sur le substrat 1 afin d'éliminer les impuretés et les oxydes natifs qui sont présents à la surface, en particulier sur les zones 3 et 4. Le nettoyage est réalisé, de manière classique, par exemple au moyen d'une gravure humide et/ou d'une gravure par plasma. Le nettoyage peut comporter, par exemple, un traitement à l'acide fluorhydrique dilué et/ou un plasma d'argon.

Une couche de métal 2 est ensuite déposée sur les zones 3, 4 et le motif 5 pendant une étape F2. La couche de métal est, de préférence, à base de nickel et déposée sur la totalité de la surface du substrat 1. La couche 2 à base de nickel est déposée, de manière classique, par toute technique adaptée qui permet le dépôt à une température suffisamment basse pour éviter la formation incontrôlée d'un germaniure ou d'un siliciure. De préférence, la température de dépôt est choisie inférieure ou égale à 100 °C. Le dépôt de la couche 2 est réalisé, par exemple, par dépôt chimique en phase vapeur, par pulvérisation cathodique, par dépôt physique en phase vapeur ou par évaporation sous faisceau d'électrons.

La couche 2 est, par exemple, une couche de nickel pur. La couche 2 peut également comporter majoritairement du nickel, la teneur en nickel étant supérieure ou égale à 50 % en poids, et un élément d'alliage. L'élément d'alliage est, de préférence, du platine, du palladium, ou un mélange de ces matériaux. L'ajout d'un élément d'alliage dans la couche 2 permet notamment d'augmenter le domaine de stabilité des germaniures et siliciures en température. L'épaisseur de la couche 2 à base de nickel est comprise entre 1 nm et 100 nm, de préférence entre 5 nm et 20 nm.

Un premier traitement thermique, noté F3 sur la figure 3, est ensuite réalisé afin de transformer au moins partiellement les zones 3 et 4 de semi-conducteurs en contact avec la couche de métal 2, respectivement, en des matériaux 6 et 7 à base de métal (Fig.4). Par matériau à base de métal, on entend un matériau métallique, c'est-à-dire ayant un comportement électrique de type métallique, et comportant un semi-conducteur. Ainsi, lors du premier traitement thermique, la couche 2 interagit avec la zone 3 en matériau semi-conducteur contenant du silicium et la zone 4 en matériau semi-conducteur contenant du germanium pour former respectivement un matériau métallique 6 contenant du silicium et un matériau métallique 7 contenant du germanium.

Ce premier traitement thermique peut être réalisé au moyen d'un traitement thermique rapide, par exemple, un recuit thermique rapide sous lampe (« Lamp-based Rapid Thermal Annealing » en anglais) ou un recuit flash (« spike anneal » en anglais).

Le premier traitement thermique est réalisé sous une atmosphère contrôlée comportant un élément bloquant sous forme gazeuse. L'élément bloquant est, de préférence, l'oxygène. L'oxygène présent dans l'atmosphère de recuit permet la formation du germaniure 7 au-dessus de la zone 4 mais bloque l'exo-diffusion du germanium le long des zones diélectriques 5 empêchant la formation d'un germaniure 7 au-dessus de ces zones 5.

La quantité en oxygène est, de préférence, suffisamment importante pour empêcher la diffusion latérale ou exo-diffusion des atomes de germanium provenant du matériau semi-conducteur de la zone 4. Cependant, la teneur en oxygène est, de préférence, suffisamment faible pour ne pas bloquer la réaction en volume entre les atomes de nickel et les atomes de germanium au niveau de la zone 4, ni bloquer la réaction en volume du nickel dans le silicium au niveau des zones 3 et/ou 4 (quand la zone 4 est en SiGe, par exemple).

De plus, la teneur en oxygène est, de préférence, suffisamment faible pour ne pas modifier de manière significative les conditions de formation des matériaux métalliques comprenant du silicium et du germanium, ni modifier de manière significative les propriétés électriques finales de ces matériaux métalliques 6 et 7.

En particulier, selon la teneur en oxygène présent dans l'atmosphère du recuit, le premier traitement thermique va former des oxydes. La quantité en oxygène doit donc être suffisamment faible pour ne pas oxyder la couche de métal 2 totalement et entamer l'oxydation des matériaux semi-conducteurs, le silicium de la zone 3 notamment.

La quantité d'oxygène dans l'atmosphère du premier traitement thermique est inférieure à 5% et supérieure à 0,01 %. Cette valeur correspond au pourcentage volumique d'oxygène gazeux dans l'atmosphère de recuit. Elle est, de préférence, comprise entre 0,01 % et 0,5 %. La quantité d'oxygène est, par exemple, de l'ordre de 0,1 %. Ainsi, une faible quantité d'oxygène est suffisante pour bloquer l'exo-diffusion des atomes de germanium en périphérie de la zone 4 et éviter une oxydation trop importante de la couche 2 à base de nickel.

Si la couche 2 est en nickel pur et si les zones 3 et 4 sont en silicium et en germanium purs respectivement, lors du premier traitement thermique, la zone 3 interagit pour former un siliciure 6 de nickel et la zone 4 réagit pour former un germaniure 7 de nickel. Lors de ce traitement thermique, l'oxygène réagit avec le germanium afin de l'empêcher de diffuser au-dessus des motifs 5 en matériau diélectrique.

Par ailleurs, selon les conditions du traitement thermique (durée, température), les matériaux métalliques 6 et 7 formés peuvent présenter des propriétés métallurgiques différentes. Les conditions du premier traitement thermique sont choisies, de préférence, de manière à obtenir les matériaux métalliques 6 et 7 les moins résistifs possibles. Ainsi, l'obtention de monosiliciure de nickel (NiSi) et de monogermaniure de nickel est recherchée. De manière analogue, si le matériau semi-conducteur contenant du germanium est un alliage de silicium-germanium, le matériau métallique recherché comporte, de préférence, autant d'atomes de nickel que d'atomes semi-conducteurs (Si et Ge).

Si les conditions du premier traitement thermique permettent la formation des phases désirées des matériaux métalliques 6 et 7, la durée et la température du traitement thermique sont suffisamment faibles pour éviter le démouillage des couches en matériaux métalliques 6 et 7. Le démouillage de ces couches se traduit par une agglomération de la couche. Il existe alors une discontinuité de l'interface entre le matériau métallique obtenu (6, 7) et le matériau semi-conducteur des zones 3 et 4 du substrat 1, ce qui nuit à la qualité du contact électrique.

La tenue en température des matériaux métalliques 6 et 7 peut être améliorée par l'ajout de platine (Pt) ou palladium (Pd) dans la couche 2 à base de nickel, comme décrit précédemment. Le phénomène de démouillage sera alors atténué.

Le premier traitement thermique est réalisé à une température comprise entre 200 °C et 600 °C dans le cas d'un substrat formé uniquement avec un semi-conducteur comprenant du germanium, avec un taux de germanium supérieur ou égal à 30 %. Dans le cas d'une co-intégration de matériaux métalliques comprenant du silicium et du germanium, le premier traitement thermique est réalisé à une température comprise entre 350 °C et 500 °C.

Pour une couche 2 à base de nickel de 1 nm à 100 nm d'épaisseur, la durée du premier traitement thermique varie entre 10 secondes et 200 secondes. L'épaisseur de la couche 2 variant, de préférence, entre 5 nm et 20 nm, la durée varie entre 30 secondes et 2 minutes.

Selon les conditions du traitement thermique et l'épaisseur de la couche à base de nickel, les cinétiques de réaction du nickel avec le silicium et le germanium sont telles qu'une partie de la couche métallique peut ne pas avoir réagi complètement. Il est alors possible que la réaction soit complète ou partielle pour les premier et second matériaux semi-conducteurs ou qu'elle soit complète pour l'un des deux et partielle pour l'autre. Cependant, dans tous les cas, après le premier traitement thermique sous atmosphère comportant de l'oxygène, le germanium de la zone 4 n'a pas diffusé vers le métal 2 au-dessus des motifs diélectriques 5 pour former le germaniure 7 au-dessus de ces motifs.

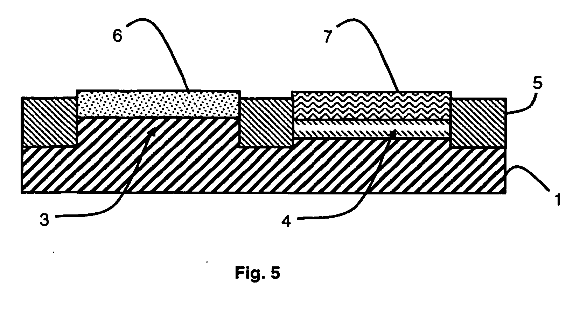

Comme illustré aux figures 3 et 4, le procédé comporte, au terme de ce premier traitement thermique, une étape d'élimination F4 de la couche de métal 2 restante n'ayant pas réagi avec le matériau semi-conducteur contenant du silicium et le matériau semi-conducteur contenant du germanium. Cette couche restante est alors retirée sélectivement vis-à-vis du matériau diélectrique formant les motifs 5 et des matériaux métalliques 6 et 7 formés (Fig.5). Cette élimination sélective est réalisée de manière classique, par exemple par la mise en contact du substrat 1 avec une solution chimique de composition appropriée.

A titre d'exemple, les solutions aqueuses permettant la gravure d'une couche composée principalement de nickel, sélectivement par rapport à un siliciure de nickel, sont à base d'acide d'halogénures, par exemple, l'acide chlorhydrique (mélange HCl/H₂O), l'acide fluorhydrique (mélange HF/H₂O) ou l'acide bromhydrique (mélange HBr/H₂O)- Ces solutions peuvent éventuellement contenir de l'acide sulfurique H₂SO₄ ou bien encore de l'acide phosphorique H₃PO₄. Le document US20070032025 décrit de nombreux exemples de solutions chimiques qui peuvent être employées pour une élimination sélective par voie aqueuse.

Lors du premier traitement thermique, la couche de métal 2 peut être en partie oxydée en surface selon la teneur en oxygène employée. L'oxyde formé ne peut être retiré et perturbe alors l'étape d'élimination de la couche 2 restante. En effet, l'oxyde formé en surface protège le métal en profondeur de la gravure. Une teneur en oxygène judicieusement choisie permet un compromis entre une oxydation réduite de la couche de métal et un blocage suffisant de la diffusion des atomes de germanium au-dessus des motifs 5.

Si les conditions du premier traitement thermique ne permettent pas d'obtenir des matériaux métalliques 6 et 7 comportant un matériau semi-conducteur Si et/ou Ge qui présentent les caractéristiques électriques recherchées, les conditions du premier traitement thermique sont choisies de manière à obtenir des matériaux métalliques 6 et 7 riches en nickel, c'est-à-dire qui comportent plus d'atomes de nickel que d'atomes de Si et/ou de Ge.

Si après le premier traitement thermique, au moins l'un des matériaux métalliques 6 et 7 obtenus présente une composition en nickel plus riche que la composition en matériau semi-conducteur, c'est-à-dire, si Ni_{X}A_{Y} avec X>Y et A=Si et/ou Ge, alors un second traitement thermique peut être réalisé lors d'une étape F5 (figure 3). Ce second traitement thermique a pour but de transformer les matériaux métalliques 6 et 7 riches en nickel en des matériaux métalliques ayant une composition égale en nickel et en matériau semi-conducteur (Si ou Ge) et qui présente une résistivité plus faible. Au moyen du second traitement thermique, des monosiliciures de nickel NiSi et des monogermaniures de nickel NiGe sont recherchés.

Ce second traitement thermique peut être réalisé avec les mêmes techniques que le premier traitement thermique, c'est-à-dire au moyen d'un traitement thermique rapide, par exemple, un recuit thermique rapide sous lampe ou un recuit flash. Ce second traitement thermique est réalisé sous une atmosphère contrôlée inerte, par exemple sous argon ou sous azote.

Le second traitement thermique est optionnel dans le cas d'un substrat formé avec uniquement un semi-conducteur comprenant du germanium. En effet, la température du premier traitement thermique peut suffire à former le germaniure dans la phase souhaitée. En revanche, il peut être nécessaire dans le cas d'un substrat avec un semi-conducteur comprenant du silicium pour finaliser la formation du monosiliciure de nickel.

De manière générale, la température du second traitement thermique est supérieure à celle du premier traitement thermique. Le second traitement thermique est réalisé à une température comprise entre 400 °C et 600 °C.

Pour une couche 2 à base de nickel de 1 nm à 100 nm d'épaisseur, la durée du second traitement thermique varie entre 10 secondes et 200 secondes.

L'épaisseur de la couche 2 variant, de préférence, entre 5 nm et 20 nm, la durée varie entre 30 secondes et 2 minutes.

A titre d'exemple, une couche de nickel ayant une épaisseur de 30 nm est déposée (Fig.3 ; F2) sur les zones en silicium et germanium. Un premier traitement thermique (F3) sous lampe de 2 minutes à 350 °C est alors réalisé sous oxygène, à une concentration de 0,1 %. Dans ces conditions, un monogermaniure de nickel NiGe 7 est directement formé dans la zone 4. Lors de ce premier traitement thermique, la zone 3 en silicium forme un siliciure de nickel 6. Si le siliciure de nickel est un mélange de monosiliciure de nickel NiSi et de disiliciure de nickel Ni₂Si, un second traitement thermique est réalisé pour transformer le disiliciure de nickel Ni₂Si en monosiliciure de nickel NiSi. Le budget thermique de ce second traitement thermique est alors choisi de manière à ne pas dégrader le monogermaniure de nickel NiGe déjà formé, notamment par démouillage. De manière classique, le nickel n'ayant pas réagi après le premier traitement thermique est éliminé avant le second traitement thermique, sélectivement par rapport aux matériaux métalliques 6 et 7 présents sur le substrat. Le retrait sélectif du nickel n'ayant pas réagi est réalisé, par exemple, au moyen d'un mélange HCl/H2O de proportion volumique 1 /10, à 55 °C pendant 4 minutes.

Si le matériau semi-conducteur de la zone 4 est un alliage de silicium-germanium, le matériau métallique 7 obtenu est également à base de l'alliage de silicium-germanium. Par ailleurs, si la couche 2 à base de nickel comporte d'autres éléments métalliques pouvant réagir avec le silicium et le germanium, par exemple du cobalt ou du platine, alors les matériaux métalliques 6 et 7 obtenus sont des mélanges de ces métaux. A titre d'exemple, le silicium peut alors réagir avec la couche 2 pour former un siliciure qui comporte majoritairement un siliciure de nickel.

Le procédé décrit peut être utilisé avec tout semi-conducteur contenant du germanium. Il est particulièrement intéressant pour la formation simultanée d'un matériau métallique contenant du silicium et d'un matériau métallique contenant du germanium. Cette co-intégration, siliciure/germaniure par exemple, est rendu possible par le fait que la température du premier traitement thermique est suffisamment élevée pour former un premier siliciure de nickel qui restera intact lors du retrait de la couche restante à base de nickel.

Cette même température est, par ailleurs, suffisante pour former en une seule fois le germaniure désiré alors que dans l'art antérieur, deux recuits sont nécessaires.

## Revendications

1. Procédé de formation de premier et second matériaux à base de métal (6, 7) dans un dispositif semi-conducteur comportant les étapes suivantes :
- prévoir un substrat (1) comportant une zone (3) en premier matériau semi-conducteur et une zone (4) en second matériau semi-conducteur comprenant du germanium séparées par un motif (5) en matériau diélectrique,
- déposer (F2) une couche de métal (2),
- réaliser un premier traitement thermique (F3), la couche de métal (2) réagissant au moins partiellement avec le premier matériau semi-conducteur et le second matériau semi-conducteur comprenant du germanium pour former respectivement le premier matériau (6) à base de métal et le second matériau (7) à base de métal et contenant du germanium,
procédé **caractérisé en ce que** le premier traitement thermique est réalisé sous une atmosphère comprenant une quantité d'oxygène comprise entre 0,01 % et 5 %.

2. Procédé selon la revendication 1, **caractérisé en ce que** la couche de métal (2) est à base de nickel.

3. Procédé selon l'une des revendications 1 et 2, **caractérisé en ce que** le premier matériau semi-conducteur comprend du silicium et le second matériau semi-conducteur comprend du germanium, avec un pourcentage de germanium supérieur ou égal à 30%.

4. Procédé selon l'une quelconque des revendications 1 à 3, **caractérisé en ce qu'**il comporte l'élimination (F4) de la couche de métal (2) n'ayant pas réagi lors du premier traitement thermique.

5. Procédé selon l'une quelconque des revendications 1 à 4, **caractérisé en ce que** la couche de métal (2) comporte un élément d'alliage.

6. Procédé selon la revendication 5, **caractérisé en ce que** l'élément d'alliage est choisi parmi le platine ou le palladium.

7. Procédé selon l'une quelconque des revendications 1 à 6, **caractérisé en ce qu'**il comporte un second traitement thermique (F5) visant à diminuer la résistivité d'au moins un des premier (6) et second (7) matériaux à base de métal.

## Patentansprüche

1. Verfahren zur Bildung eines ersten und eines zweiten Materials auf Metallbasis (6, 7) in einer Halbleitervorrichtung, das die folgenden Schritte umfasst:
- Vorsehen eines Substrats (1), das einen Bereich (3) aus einem ersten Halbleitermaterial und einen Bereich (4) aus einem Germanium umfassenden zweiten Halbleitennaterial, die durch ein Muster (5) aus dielektrischem Material getrennt sind, umfasst,
- Abscheiden (F2) einer Metallschicht (2),
- Durchführen einer ersten Wärmebehandlung (F3), wobei die Metallschicht (2) wenigstens teilweise mit dem ersten Halbleitermaterial und dem Germanium umfassenden zweiten Halbleitermaterial reagiert, um das erste Material (6) auf Metallbasis bzw. das zweite Material (7) auf Metallbasis, welches Germanium enthält, zu bilden,
Verfahren, **dadurch gekennzeichnet, dass** die erste Wärmebehandlung unter einer Atmosphäre durchgeführt wird, die eine Sauetstoffmenge zwischen 0,01 % und 5 % umfasst.

2. Verfahren nach Anspruch 1, **dadurch gekennzeichnet, dass** die Metallschicht (2) auf Nickelbasis ist.

3. Verfahren nach einem der Ansprüche 1 und 2, **dadurch gekennzeichnet, dass** das erste Halbleitermaterial Silizium umfasst und das zweite Halbleitermaterial Germanium, mit einem Germanium-Prozentsatz von über oder gleich 30 %, umfasst.

4. Verfahren nach einem der Ansprüche 1 bis 3, **dadurch gekennzeichnet, dass** es das Entfernen (F4) der Metallschicht (2), die während der ersten Wärmebehandlung nicht reagiert hat, umfasst.

5. Verfahren nach einem der Ansprüche 1 bis 4, **dadurch gekennzeichnet, dass** die Metallschicht (2) ein Legierungselement umfasst.

6. Verfahren nach Anspruch 5, **dadurch gekennzeichnet, dass** das Legierungselement aus Platin oder Palladium ausgewählt ist.

7. Verfahren nach einem der Ansprüche 1 bis 6, **dadurch gekennzeichnet, dass** es eine zweite Wärmebehandltuag (F5) umfasst, die darauf abzielt, den spezifischen Widerstand von wenigstens einem der ersten (6) und zweiten (7) Materialien auf Metallbasis zu verringern.

## Claims

1. Method for forming first and second metal-based materials (6, 7) in a semi-conductor device comprising the following steps:
- providing a substrate (1) comprising an area (3) made from a first semi-conductor material and an area (4) made from a second semi-conductor material comprising germanium separated by a pattern (5) made from dielectric material,
- depositing (F2) a metal layer (2),
- performing a first heat treatment (F3), the metal layer (2) reacting at least partially with the first semi-conductor material and the second semi-conductor material comprising germanium to respectively form the first metal-based material (6) and the second metal-based material (7) containing germanium,
method **characterized in that** the first heat treatment is performed in an atmosphere comprising a quantity of oxygen comprised between 0.01 % and 5%.

2. The method according to claim 1, **characterized in that** the metal layer (2) is nickel-based.

3. The method according to one of claims 1 and 2, **characterized in that** the first semi-conductor material comprises silicon and the second semi-conductor material comprises germanium, with a percentage of germanium greater than or equal to 30 %.

4. The method according to any one of claims 1 to 3, **characterized in that** it comprises removal (F4) of the metal layer (2) that did not react during the first heat treatment.

5. The method according to any one of claims 1 to 4, **characterized in that** the metal layer (2) contains an alloy element.

6. The method according to claim 5, **characterized in that** the alloy element is chosen from platinum or palladium.

7. The method according to any one of claims 1 to 6, **characterized in that** it comprises a second heat treatment (F5) to reduce the resistivity of at least one of the first (6) and second (7) metal-based materials.
